# EUROPÄISCHE PATENTSCHRIFT

(11) **EP 2 537 802 B1**
(45) Veröffentlichungstag und Bekanntmachung des Hinweises auf die Patenterteilung: **11.05.2016**
(21) Anmeldenummer: 12170845.7
(22) Anmeldetag: 05.06.2012
(51) Int. Cl.: C01B 33/035, C23C 16/00, H05B 6/00, B01J 19/00, B01J 19/08

(54) **VERFAHREN ZUR STROMVERSORGUNG EINES REAKTORS**
METHOD FOR SUPPLYING CURRENT TO A REACTOR
PROCÉDÉ DE FABRICATION DE L'ALIMENTATION ÉLECTRIQUE D'UN RÉACTEUR

(30) Priorität: 22.06.2011 DE 102011077967
(43) Veröffentlichungstag der Anmeldung: 26.12.2012
(73) Patentinhaber: Wacker Chemie AG, 81737 München (DE)
(72) Erfinder: Ellinger, Norbert, 84389 Postmünster (DE); Ring, Robert, 84533 Haiming (DE); Wiesbauer, Josef, 5280 Braunau (AT)
(74) Vertreter: Potten, Holger

(56) Entgegenhaltungen:
- WO-A1-2010/068849
- WO-A1-2011/120112
- US-A- 3 286 685
- MELO M A C ET AL: "Experience with on-line monitoring of capacitance and tangent delta of condensive bushings", TRANSMISSION AND DISTRIBUTION CONFERENCE AND EXPOSITION: LATIN AMERICA, 2008 IEEE/PES, IEEE, PISCATAWAY, NJ, USA, 13. August 2008 (2008-08-13), Seiten 1-6, XP031346045, ISBN: 978-1-4244-2217-3

## Beschreibung

Die Erfindung betrifft ein Verfahren zur Stromversorgung eines Reaktors.

Im Besonderen betrifft die Erfindung die Stromversorgung von chemischen Reaktoren, die eine Reaktorkammer umfassen, in der Reaktionsgase mittels Heizelementen auf eine bestimmte Temperatur aufgeheizt werden, wobei die Heizelemente durch direkten Stromdurchgang beheizt werden. Dazu sind die Heizelemente aus einem elektrisch leitfähigen Material gefertigt und an eine Stromversorgung angeschlossen. Ebense betrifft die Erfindung die Stromversorgung von sog. Siemens-Reaktoren.

Bei der Abscheidung von Polysilicium nach dem Siemens-Prozess wird hochreines elementares Silicium aus der Gasphase an der Oberfläche von Siliciumstäben abgeschieden. Dabei wird in einem Abscheidereaktor an der Oberfläche eines auf 900 bis 1200 °C beheizten Silicium-Dünnstabes aus einer Mischung von Wasserstoff und Halogensilanen (wie z.B. Trichlorsilan) oder einer wasserstoffhaltigen Siliciumverbindung elementares Silicium aus der Gasphase abgeschieden.

Die Siliciumstäbe werden dabei im Reaktor von speziellen Elektroden gehalten, die in der Regel aus hochreinem Elektrographit bestehen. Jeweils zwei Dünnstäbe mit unterschiedlicher Spannungspelung an den Elektrodenhalierungen sind am anderen Dünnstabende mit einer Brücke zu einem geschlossenen Stromkreis verbunden. Über die Elektroden und deren Elektrodenhalterungen wird elektrische Energie zur Beheizung der Dünnstäbe zugeführt. Über Einlassdüsen an der Bodenplatte des Abscheidereaktors wird eine Mischung von Wasserstoff und Halogensilanen zugefügt. Dabei zersetzen sich die Halogensilane an der Oberfläche der Dünnstäbe. Dabei wächst der Durchmesser der Dünnstäbe. Nach dem Erreichen eines gewünschten Solldurchmessers der Siliciumstäbe wird der Abscheideprozess beendet, die glühenden Siliciumstäbe abgekühlt und ausgebaut.

Eine besondere Bedeutung kommt hier dem Schutz der Elektrode und der die Elektrodenhalterung umgebenden Dichtung zu. Da der Trend zu immer längeren und schwereren Stäben in kürzeren Abscheidezyklen geht, ist gerade die Anordnung und Form der Elektrodendichtungssachutzkörper sowie das Material der zu schützenden Dichtung von Bedeutung. Denn durch eine optimierte Anordnung können die mögliche Ausbeute und oder Qualität beeinflussende Störungen beim Prozess der Polysiliciumabscheidung vermieden werden. Zu diesen möglichen Störungen gehören elektrische Ausfälle durch z.B. Erdschlüsse während der Abscheidung und Undichtigkeit des Reaktors über die Durchführung der stromzuführenden Elektroden in dem Reaktorboden des CVD Reaktors.

Auch je nach der späteren Verwendung der so erzeugten Siliciumstäbe werden sehr unterschiedliche Anforderungen an die Siliciumstäbe und den Abscheideprozess, und somit an die Elektroden und deren Schutz gestellt. Wird beispielsweise das polykristalline Silicium später in Siliciumbruchstücken für Solar- und Elektronikanwendungen verwendet, dürfen die Siliciumstäbe während oder nach dem Abscheideprozess im Abscheidereaktor nicht umfallen oder durch austretende Fremdstoffe aus z.B. produktberührenden Dichtungsmaterialien verunreinigt werden.
In dem WO-Patent 2010/083899 A1 ist eine Elektrodenschutzvorrichtung nach dem Stand der Technik offenbart. Dabei werden Dünnstäbe in einem Grafitadapter, der in einen Grafitspannring eingreift, der selbst über einen Quarzring mit der Bodenplatte des CVD Reaktors zur Herstellung von polykristallinem Silicium nach dem Monosilan-Prozess zusammenwirkt beschrieben.

Zu den die mögliche Ausbeute und oder Qualität beeinflussenden Störungen beim Prozess der Polysiliciumabscheidung gehören elektrische Ausfälle durch Erdschlüsse während der Abscheidung. Durch diese Störung entsteht eine Differenz zwischen der realen Ausbringung und der möglichen maximalen Ausbringung.

Im Stand der Technik wurde versucht, dieses Problem durch Dichtung und Isolierung der Elektrodenhalterungen zu lösen.

Aus WO 2010/083899 A1 ist bekannt, die Dichtungen der Elektrodenhalterungen mittels Schutzringen aus Quarz gegen thermische Belastung abzuschirmen.

In DE 23 20 303 A1 ist eine Vorrichtung beschrieben zum Herstellen von Stäben und Rohren aus Silicium durch Abscheiden des betreffenden Halbleitermaterials aus der Gasphase an der Mantelfläche eines erhitzten langgestreckten Trägers, insbesondere aus Silicium oder Graphit, bestehend aus einem eine Grundplatte aus Metall aufweisenden Reaktionsgefäß welches mit mindestens einer zur Halterung eines Endes des langgestreckten Trägers und zur Beheizung des Trägers dienenden Elektrode versehen ist, die elektrisch isoliert und dicht durch die Grundplatte hindurchgeführt ist, dadurch gekenntzeichnet, dass ein erster aus Metall bestehender Elektrodenteil unter Zwischenfügung einer abdichtenden Schicht aus inertem, isolierenden Material, insbesondere Tetrafluorpolyäthylen, in der Grundplatte befestigt ist und einen in den Reaktionsraum ragenden Vorsprung aufweist, auf den ein weiterer aus Metall oder Kohlenstoff bestehender Elektrodenteil auswechselbar aufsitzt, der an seiner freien Oberfläche die zur Aufnahme und Halterung des Trägers bestimmte Passfläche besitzt.

Ein erster aus Metall bestehender Teil der Elektrodenhalterung ist also unter Zwischenführung einer abdichtenden Schicht aus inertem isolierendem Material in der Bodenplatte befestigt .

JP 2009-221058 A2 offenbart eine Abdichtung und Isolierung durch den Einsatz einer speziellen Zirkonium-Keramik, von flexiblem Graphit, und beschichteten O-Ringen als Dichtung. Solche Materialien weisen eine Hochtemperaturbeständigkeit auf und ermöglichen eine Versiegelung des Spalts zwischen Elektroden und Bodenplatte.

WO 2010/066849 A1 beschreibt eine verbesserte thermische Isolierung im Bereich der Durchführung der Elektrodenhalterung durch die Bodenplatte durch Einsatz eines Metallkörpers, der mit einer isolierenden oborflächenbeschichtung versehen ist.

US 3286685 A offenbart eine Vorrichtung, bestehend aus einer Grundplatte, einem aus einem darüber gestülpten, am Rand mit der Grundplatte gasdicht verbundenen Gefäß sowie einer oberhalb der Grundplatte angeordneten Schutzplatte aus dem gleichen Material wie das Gefäß, wobei die dem Niederschlageraum zugewandte Fläche der Grundplatte plan geschliffen ist und das auf ihr die Schutzplatte aufliegt. Die Grundplatte ist mit einem Durchgangskanal versehen, in welchem über eine elektrische Zwischenisolation z.B. aus PTFE, der elektrische Durchführungsleiter getragen ist. Zur Bildung eines geschlossenen Behälters ist weiterhin ein glockenförmiges Teil vorgesehen, das an seinem unteren Rand mit einem Flansch über eine dazwischen gelegte Dichtungsscheibe, z.B. aus PTFE, auf der oberen fläche der Grundplatte festgespannt werden kann.

Allerdings zeigen die bislang bekannten Vorrichtungen keinen ausreichenden Schutz der Dichtung der Elektrodenhalterung. Dies hat zur Folge, dass die Ausfallwahracheinlichkeit aufgrund korrosiver Effekte sowie Erdschlüssen erhöht ist. Zudem wurde bisher noch kein ausreichender Schutz der Dichtung vor Korrosion und damit Austrag von die Produktqualität beeinflussenden Stoffen (insbes. Dotierstoffe) gefunden.

DE 3024320 A1 offenbart eine Vorrichtung zur Hochtemperaturbehandlung von Gasen, bestehend aus einem wärmeisolierten Gehäuse mit Gaseinlass- und Gasauslassöffnungen sowie zwischen diesen Öffnungen angeordneten, durch direkten Stromdurchgang beheizten, inerten Widerstandsheizern. Die Aufheizung der elektrisch leitenden Widerstandskörper erfolgt vorzugsweise durch Sternschaltung in einem symmetrischen Mehrphasenwechselstromsystem. Dabei lassen sich einzelnen Heizergruppen unterschiedlich zueinander regeln, also unterschiedlich durch elektrischen Stromdurchgang beheizen.

Ein Beispiel für eine solche Vorrichtung ist ein Reaktor zur Konvertierung von Siliciumtetrachlorid zu Trichlorsilan.

Trichlorsilan wird im Siemens-Prozess zur Herstellung von polykristallinem Silicium verwendet. Dabei wird Silicium in einem Reaktor an erhitzten Dünnstäben abgeschieden. Als Prozessgas wird Trichlorsilan in Anwesenheit von Wasserstoff verwendet. Bei der Umsetzung von Trichlorsilan (Disproportionierung) in abgeschiedenes Silicium entstehen große Mengen an Siliciumtetrachlorid.

Aus Siliciumtetrachlorid kann beispielsweise durch Reaktion mit Wasserstoff und Sauerstoff bei hohen Temperaturen in Brennkammern hoch disperse Kieselsäure produziert werden.

Die wirtschaftlich interessanteste Verwendung von Siliciumtetrachlorid ist jedoch die Konvertierung zu Trichlorsilan. Diese erfolgt durch Reaktion von Siliciumtetrachlorid mit Wasserstoff in Trichlorsilan und Chlorwasserstoff. Dadurch ist es möglich, aus dem bei der Abscheidung entstehenden Nebenprodukt Siliciumtetrachlorid Trichlorsilan zu erzeugen und jenes Trichlorsilan wieder dem Abscheideprozess zuzuführen, um elementares Silicium zu erzeugen.

Die Konvertierung von Siliciumtetrachlorid mit Wasserstoff zu Trichlorsilan findet üblicherweise in einem Reaktor bei hohen Temperaturen, bei wenigstens 600°C, idealer weise bei wenigstens 850°C sowie bei einem Druck von 0-30bar statt.

Zu diesem Zweck wird elektrischer Strom direkt durch die leitfähigen Heizelemente geleitet und die elektrische Energie im Heizelement durch den elektrischen Widerstand in Wärme umgewandelt.

Die Heizelemente bestehen üblicherweise aus Kohlenstoff enthaltenden Materialien wie z.B. Graphit, CFC, Siliziumcarbid oder ähnlichen Werkstoffen.

Es ist bekannt, dass die kohlenstoffhaltigen Reaktoreinbauteile bei der Konvertierung von Siliciumtetrachlorid in Anwesenheit von Wasserstoff einem chemischen Angriff ausgesetzt sind.

Durch don chemischen Angritt dieser kohlenstoffhaltigen Bauelemente kommt es zu Kohlenstoffablagerungen, die elektrisch leitfähig sind und dadurch zu Erdschlüssen des elektrischen Energienetzes führen können. Darüber hinaus kann es durch don chemischen Angriff auch zu Bauteilversagen der inneren Aufbauten kommen, hier kommt es dann zu Abplatzungen oder Absplitterungen von Kleinteilen, die wiederum zu Erdschlüssen führen können. Das Problem bei diesen Erdschlüsse ist die Tatsache, dass sie nicht von Schäden der Elektrodendichtungen unterschieden werden können. Bei Schäden an der Elektrodendichtung muss die Stromversorgung und der Reaktor außer Betrieb genommen werden, da es durch anhaltenden Betrieb zu Undichtigkeit bzw. Reaktionsgasaustritt kommen kann, welcher verhindert werden muss.

Üblicherweise werden nichtmetallische bzw. nicht elektrisch leitfähige Dichtungen für Elektroden verwendet, da diese eine Doppelfunktion nämlich elektrische Isolierung der Elektrode von der Reaktorwand und Dichtfunktion erfüllen. Allerdings sind die Temperaturen in diesen Reaktoren so hoch, dass es kaum elektrisch isolierende und zugleich chemisch beständige Materialien gibt, welche die Funktion einer elektrischen Isolierung und einer druckhaltenden Dichtung erfüllen.

Melo MAC et al, "Experience with on-line monitoring of capacitance and tangent delta of condensive bushings", Transmission and Distribution Conference and Exposition: Latin America, 2008 IEEE/PES, 20080813 IEEF, Piscataway, NJ, USA - ISBN 978-1-4244-2217-3; TSBN 1-4244-2217-5, offenbart eine Dichtung aus Schichten von leitfähigem und nichtleitfähigem Material.

WO 2011/120112 A1 offenbart ein Überwachungssystem des dielektrischen Zustands von Hochspannungsausrüstungen mit kapazitiver Isolierung, wie etwa kapazitive Buchsen, Stromwandler, Potenzialwandler und dergleichen.

Außerdem kann versucht werden, die Dichtungen durch zusätzliche Einbauten im Reaktor vor zu hohen Temperaturen zu schützen.

Trotzdem kann ein Dichtungsschaden, ausgelöst durch ungewollte elektrische Ströme von einer Elektrode über die Reaktorwand zu einer anderen Elektrode, mit solchen Maßnahmen nicht ausgeschlossen werden.

Aus dieser Problematik ergab sich die Aufgabenstellung der vorliegenden Erfindung.

Die Aufgabe der Erfindung wird gelöst durch das Verfahren nach Anspruch 1.

Bevorzugte Ausführungen des Verfahrens sind in den abhängigen Ansprüchen beansprucht.

Bei einem Verfahren zur Stromversorgung eines Reaktors, bei dem eine oder mehrere durch eine Wandung des Reaktors geführte Elektroden eines elektrischen Energienetzes, welches galvanisch gegen Erde isoliert ist, jeweils mit einem elektrisch leitfähigen Element verbunden sind, wodurch jeweils eine Betriebsspannung an dem wenigstens einen elektrisch leitfahigen Element anliegt und durch dieses elektrischer Strom fließt, wobei sich zwischen Wandung des Reaktors und Elektrode jeweils eine Dichtung aus einem elektrisch isolierenden Material befindet, wobei das elektrische Energienetz auf Isolationsfehler überwacht wird und die Unterschreitung eines bestimmten Isolationswiderstandes eine Abschaltung der elektrischen Energiezufubr auslöst, kann die Schaltschwelle unter Berücksichtigung mindestens eines Parameter aus der Gruppe bestehend aus Dichtungsgeometrie, Dichtungsmaterial, Versorgungsspannung und des maximal möglichen elektrischen Energieeintrags in die Dichtung unmittelbar vor Abschaltung, ausgelöst durch den maximal theoretisch möglichen Kriechstrom über die Dichtung, ermittelt werden

Ein solches Verfahren wird vorzugsweise angewendet beim Siemens-Prozess, wobei die elektrisch leitfähigen Elemente Dünnstäbe sind, die aufgeheizt werden und aut denen silicium abgeschieden wird. Die Wandung des Reaktors ist in diesem Fall eine Bodenplatte des Reaktors. Die isolierende Dichtung befindet sich vorzugsweise zwischen Bodenplatte und Elektrode bzw. Elektrodenhalterung. Es ist auch bevorzugt, das Vorfahren bei thermischen Behandlungen, besonders bevorzugt Temperaturbehandlungen, von Gasen anzuwenden. Die elektrisch leitfähigen Elemente sind in diesem Fall vorzugsweise Kohlenstoff enthaltende Heizelemente bzw. Wideratandsheizer, die dazu dienen, das zu behandelnde Gas oder Gasgemisch auf eine bestimmte Temperatur von wenigstens 300°C aufzuheizen.

Die behandelten Gase umfassen vorzugsweise wenigstens eine Silicium enthaltende Komponente. Besonders bevorzugt handelt es sich beim Silicium enthaltenden Gas um Siliciumtetrachlorid oder um ein anderes Halogensilan. Vorzugsweise ist auch Wasserstoff in der Behandlungskammer enthalten.

Ohne den allgemeinen Erfindungsgedanken in irgendeiner Weise einzuschränken sei an dieser Stelle boispielhaft die zuvor beschriebene Konvertierung von Siliciumtetrachlorid genannt. Bei der Konvertierung ist Wasserstoff als zweites Eduktgas erforderlich. Die Konvertierung findet vorzugsweise bei einer Temperatur von 800 bis 1500°C und bei einem Druck von 0 bis 30 bar oder höher statt. Besonders bevorzugt ist es, dabei einen Druck zu wählen, der größer oder gleich einem überkritischen Druck der Eduktgase ist. Das Molverhältnis H2:STC beträgt vorzugsweise 1:1 bis 10:1.

Die Elektroden der Stromversorgung weisen eine isolierende Dichtung auf. Dabei wird eine an die verwendete Dichtung angepasste Isolationsüberwachung verwendet.

Die Erfinder haben erkannt, dass es erforderlich ist, einen die Dichtung zerstörenden elektrischen Kriechstrom bzw. Lichtbogen zu erkennen und dann frühzeitig abzuschalten.

Gleichzeitig soll aber die Laufzeit des Reaktors bis zur nächsten Demontage und Reinigung trotz der leitfähigen Verschmutzung so hoch wie möglich gehalten werden.

Ein Lichtbogen innerhalb des Reaktors von einem elektrischen Potential zu einem anderen ist nur dann die Dichtung zerstörend, wenn er in der Nähe der Dichtung stattfindet.

Wenn sich die Heizelemente weit entfernt von der Elektrode berühren ohne andere Teile berühren, so stellt dies wegen der massiven Bauweise des Reaktors üblicherweise kein Problem der.

Sofern das elektrische Energienetz geerdet ist, ist ein Lichtbogen oder Kriechstrom nur dann die Dichtung zerstörend, wenn er von der Elektrode über die Dichtung, die gleichzeitig auch Isolierung ist, auf die Reaktorwand zündet.

Andernfalls kann ein die Dichtung zerstörender Lichtbogen oder Kriechstrom nur auftreten, wenn er von einer Elektrode über die zugehörige Elektrodendichtung zur Reaktorwand und dann wiederum über die Elektrodendichtung einer zweiten Elektrode zu dieser Elektrode zündet.

In beiden Fällen ist die Reaktorwand Teil des Lichtbogenstromkreises.

In einem geerdeten Netz (Reaktorwand ist geerdet und mit dem Potential des speisenden Netzes verbunden) kann durch eine Fehlerstromerkennung ein Fehlerstrom von der Elektrode über die Dichtung zur Erde erkannt und abgeschaltet werden. Nachteil dieser Anordnung ist die Tatsache, dass ein Fehler über eine Dichtung ausreicht, um eine Abschaltung zu erzwingen. Daher ist eine solche Anordnung weniger bevorzugt.

Bevorzugt ist die Ausführung des speisenden Netzes als von der Erde galvanisch getrenntes Netz.

Dieses galvanisch getrennte Netz wird vorzugsweise durch handelsübliche Isolationsüberwachungsgeräto überwacht, die technologisch auf den bekannten Prinzipien der Spannungsüberlagerung jeglicher Art gegen Erde basieren.

Falls es nun durch Verschmutzung oder thermische Schäden zu Isolationsfehlern der Elektrodenisolierung kommt, so kann frühzeitig abgeschaltet werden, ohne dass es zu Dichtungsschäden durch Kriechströme oder Lichtbögen kommt.

Untersuchungen haben gezeigt, dass erst Isolationsfehler deutlich unter 10 Ohm wirklich zu Dichtungsschäden führen, im Betriebsfall aber auch Isolationsfehler bis hinab zu 10 Ohm auftreten können.

Aus diesem Grund ist zur Dichtungsüberwachung ein Gerät mit einem Messbereich ab 0 Ohm bevorzugt.

Die Schaltschwelle liegt bevorzugt im Widerstandsbereich zwischen 0 und 1000 Ohm und besonders bevorzugt zwischen 0-100 Ohm und ganz besonders bevorzugt zwischen 0-10 Ohm.

Unter Berücksichtigung der Dichtungsausführung kann nun eine maximal zulässige Verlustleistung bei einem Isolationsfehler definiert werden.

Die maximale Verlustleistung wird definiert durch einen maximalen Energieeintrag, der für den jeweiligen Materialtyp und der konstruktiven Ausführung der Dichtung zerstörungsfrei zulässig ist. Zusätzlich wird vorzugsweise ein Sicherheitsabstand berücksichtigt.

Aus dieser maximal zulässigen Verlustleistung und der Betriebsspannung der Heizelemente kann dann dynamisch ein minimaler zulässiger Isolationsfehlerwiderstand errechnet werden, bis zu dem kein Dichtungsschaden eintritt.

Je niedriger hier die Elektrodenbetriebsspannung ist, umso niedriger darf bei konstanter Verlustleistung der Isolationsfehler sein.

Durch entsprechende Erhöhung der berechneten Werte kann vor der Abschaltung auch ein Voralarm erzeugt werden, der die Möglichkeit gibt, die Anlage gezielt auszufahren.

Das erfindungsgemäße Verfahren ermöglicht also die Erkennung von drohenden Dichtungsschäden indirekt über den Isolationswiderstand des elektrischen Heizernetzes das als galvanisch isoliertes Netz ausgeführt ist.

Vorzugsweise erfolgt eine Abschaltung der Anlage bei Erreichen der Schaltschwelle. Auf diese Weise wird die Schädigung der Dichtung durch Kriechströme bzw. Lichtbögen und damit Gasaustritt verhindert.

Zur Maximierung der Anlagenverfügbarkeit kann die Abschaltgrenze in Abhängigkeit von der Betriebsspannung angepasst werden.

Bevorzugt wird die Schaltschwelle einmalig unter Einbeziehung der Dichtungsgeometric und/oder der Betriebsspannung und/oder dem unmittelbar vor Abschaltung maximal möglichen elektrischen Energieeintrag in die Dichtung, ausgelöst durch den theoretisch möglichen Kriechstrom über die Dichtung ermittelt.

Auch bevorzugt wird die Schaltschwelle während des Betriebes kontinuierlich unter Einbeziehung der Dichtungsgeomotrie und/oder der Betriebsspannung und/oder dem unmittelbar vor Abschaltung maximal möglichen elektrischen Energieeintrag in die Dichtung, ausgelöst durch den theoretisch möglichen Kriechstrom über die Dichtung ermittelt.

Das erfindungsgemäße Verfahren ermöglicht die Erkennung eines drohenden Dichtunosschadens durch Einbetten eines leitfähigen Kernes und Überwachung dieses Kernes auf Isolationsfehler.

Dabei ist es möglich, alle Elektroden bzw. Elektrodendichtungen eines Reaktors gemeinsam zu überwachen.

Besonders bevorzugt ist es jedoch, die Überwachung der Elektroden eines Reaktors einzeln vorzunehmen.

Auch eine Überwachung von zwei oder mehr untereinander isolierten Dichtungskernen mit verschiedenen Warnstufen ist denkbar.

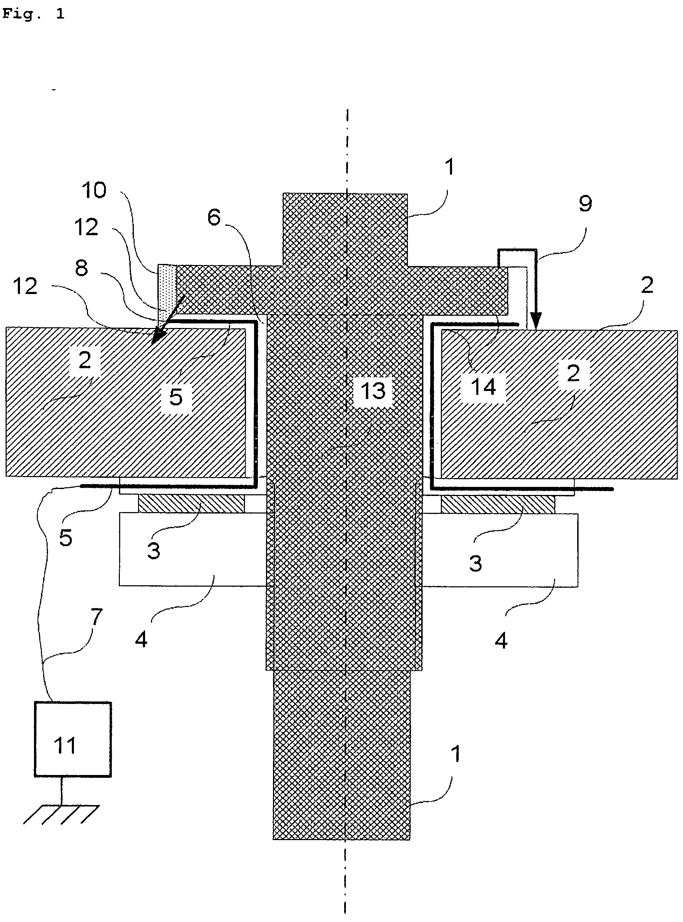

**Fig. 1** zeigt eine Stromdurchführungsanordnung (Elektrode) von elektrischer Energie durch eine Behälterwand.

### Liste der verwendeten Bezugszeichen

- **1**: Oberer Elektrodenkontakt
- **2**: Behälterwand
- **3**: Unterlegscheibe
- **4**: Schraubenmutter
- **5**: Elektrisch leitfähiger Dichtungskern
- **6**: Elektrisch isolierende Dichtung
- **7**: Elektrische Verbindung zwischen dem Dichtungskern und der Isolationsüberwachung
- **8**: Kontaktstelle des Fehlerstromes mit dem leitfähigen Dichtungskern.
- **9**: Kriechstrecke bzw. Stromweg bei völlig unbeschädigter Dichtung
- **10**: Dichtungsbeschädigung
- **11**: Isolationsüberwachungsgerät
- **12**: Strompfeil im Isolationsfehlerfall kurz vor Beschädigung der Dichtung im Bereich der Dichtfläche
- **13**: Elektrode
- **14**: Dichtflächen

Im normalen Betriebsfall fungiert Dichtung **6** als elektrische Isolierung zwischen Elektrode **13** und Behälterwand **2.**

In elektrochemischen Reaktoren mit leitfähiger Verschmutzung oder leitfähigen Ablagerungen im Inneren ist es nun möglich, dass es zu Kriechströmen von der Elektrode zur Behälterwand oder von einer Elektrode zu einer anderen Elektrode über die Behälterwand kommt.

Diese elektrischen Kriechströme können so groß sein, dass hierdurch die Dichtfunktion der Dichtung **6** durch elektrischen Energieeintrag beeinträchtigt wird. Dies wird beispielsweise verursacht durch thermische Zersetzung des Dichtungsmaterials oder durch Verlust der mechanischen Festigkeit des Dichtungsmaterials.

Dies kann je nach Reaktoranwendung wegen austretender Gase gefährlich sein, ist in jedem Fall aber unerwünscht.

Üblicherweise werden diese Kriechströme durch eine Fehlerstromüberwachung im geerdeten Versorgungsnetz oder durch eine Isolationsüberwachung im ungeerdeten Netz erkannt.

Nachteil dieser Systeme ist, dass sie meist sehr sensibel Ansprechen und auf alle Kriechströme reagieren. Kriechströme die, innerhalb des Reaktors zwischen zwei Heizelemente auftreten und unkritisch sind, können auf diese Weise nicht von die Dichtung zerstörenden Kriechströmen unterschieden werden. Es kommt also häufig vor, dass Reaktoren unnötig vorzeitig abgestellt werden müssen.

Das Verfahren ermöglicht es, einen die Dichtung zerstörenden Kriechstrom von anderen Kriechströmen zu unterscheiden und damit die Verfügbarkeit des elektrochemischen Reaktors zu erhöhen.

Hierfür wird in die Dichtung, die gleichzeitig elektrische Isolierung ist, eine leitfähige Schicht (Metallkern) eingebettet, die elektrisch mit einem handelsüblichen Isolationsüberwachungsgerät überwacht werden kann.

Im Fall eines Kriechstromes über die Dichtung **8** wird vor dem Schaden an der eigentlichen Dichtungsfläche die isolierende Einbettung **10** beschädigt.

Der leitfähige Dichtungskern 5 erhält elektrischen Kontakt zur Umgebung, was sich als deutlicher Abfall des Isolationswiderstandes des eigentlich hochohmig eingebetteten Metallkerns bemerkbar macht.

Dieser Abfall des Isolationswiderstandes kann dann von handelsüblichen Isolationsüberwachungsgeräten **11** detektiert und zur Vorwarnung oder Abschaltung der elektrischen Energieversorgung des Reaktors herangezogen werden.

Auf diese Weise wird der Reaktor nur noch bei gefährlichen bzw. unerwünschten Kriechströmen abgeschaltet.

Unkritische Kriechströme innerhalb des elektrochemischen Reaktors werden nicht mehr erkannt und führen auch nicht zu einer Abschaltung.

Bei mehreren Elektroden je Reaktor können alle leitfähigen Dichtungskerne eines Reaktors außerhalb oder innerhalb des Reaktors elektrisch verbunden und einmalig der Isolationswiderstand gegen den Reaktorbehälter überwacht werden.

Selektiver ist die Überwachung aber, wenn man jede Elektrode einzeln oder in Gruppen überwacht und je Dichtung oder Gruppe eine Isolationsüberwachung installiert.

Die elektrische Leitfähigkeit des Kerns ist in einem sehr großen Bereich wählbar, sollte sinnvoller weise aber mindestens um den Faktor 100 größer sein, als die el. Leitfähigkeit des Dichtungsmaterials.

Das Kernmaterial wird üblicherweise aus der Familie der elektrisch leitfähigen Feststoffe gewählt, wie z.B. Metalle, Graphit, Kohlenstoff, leitfähige Kunststoffe usw. und kann verschiedene Formen aufweisen (Blech, Gitter, Fasermatte usw.)

Bevorzugt werden Gitter oder Fasermatten eingesetzt, weil hier das Dichtungsmaterial bei der Herstellung außen herum verpresst oder gegossen werden kann und damit ein kompakter Körper entsteht und die Dichtfläche oft sogar stabilisiert und das Fließverhalten unter Druck der meist verwendeten Kunststoffen auf Kohlenwasserstoffbasis und/oder Fluorwasserstoffbasis verbessert.

Es sind aber auch lose Schichtsysteme, die sich aus den verschiedenen zuvor genannten Materialien zusammensetzen, denkbar oder auch mehrfach ineinander gesteckt Hülsen, welche den leitfähigen Kern elektrisch von den übrigen Potentialen (Elektrode bzw. Reaktormantel) trennen.

Die Fehlererkennung ist auch ohne Isolationsüberwachungsgerät mittels eines Hilfsspannungsnetzes und einer beliebigen Stromüberwachung möglich, z.B. mit Sicherungen oder einer beliebigen Strommessung mit Schaltschwellen für Vorwarnung und/oder Abschaltung.

Hierzu wird der Metallkern mit einem geerdeten Hilfspotential elektrisch verbunden. Ein Stromfluss signalisiert dann den Fehlerfall.

Hierfür kann für mehrere Elektroden ein Hilfsspannungsnetz benutzt werden.

Die Stromüberwachung der einzelnen Elektrodenkontakte kann dann je nach Anforderung einzeln oder für alle Elektroden gemeinsam erfolgen.

Des Weiteren haben die Erfinder im Rahmen der Erfindung erkannt, dass die thermische Belastung der Elektrodendichtungen dadurch reduziert werden kann, dass die Dichtung auf die meist gekühlte Elektrode aufgeschrumpft wird und die Wandstärke der Dichtung auf das elektrisch und mechanisch notwendige Maß reduziert wird.

Die Dichtungen enthalten üblicherweise Polymere, bevorzugt ist die Verwendung von Polytetrafluorethylen (PTFE).

Die Elektrode wird üblicherweise mit Wasser gekühlt. PTFE dehnt sich unter Wärme aus. Auf diese Weise kann die Dichtung den Kontakt zur wassergekühlten Elektrode und damit die Kühlung verlieren.

Dies kann durch das Aufschrumpfen der Dichtung verhindert werden.
Dazu wird die Dichtung erhitzt, was zu ihrer Ausdehnung führt, und anschließend schnell auf die Elektrode gezogen. Die Dichtung schrumpft beim Erkalten wieder und presst sich so der Elektrode auf und bleibt sehr fest mit dieser verbunden.
So kann die Dichtung den Kontakt zur Elektrode stets behalten und durch die Elektrode von innen gekühlt wird.

Ein Aufschrumpfen einer PTFE-Dichtung auf die Elektrode knapp unter der Zersetzungstemperatur bei ca. 200-350°C ist bevorzugt, kann aber auch schon bei niedrigeren Temperaturen erfolgen.

Die minimale Wandstärke der Dichtung ergibt sich aus den elektrischen und mechanischen Erfordernissen der Dichtung. Bevorzugt liegt die Wandstärke zwischen 0,1 bis 3 mm, besonders bevorzugt bei ca. 0,5-2mm.

Die thermische Belastung der Dichtung wird dadurch deutlich reduziert. Es kommt seltener zu Dichtungsschäden mit darauf folgenden Reaktorabschaltungen, obwohl die Wandstärke der Dichtung im Vergleich zu üblichen 5mm reduziert ist.

## Patentansprüche

1. Verfahren zur Stromversorgung eines Reaktors, wobei eine oder mehrere durch eine Wandung des Reaktors geführte Elektroden eines elektrischen Energionetzon, welches galvanisch gegen Erde isoliert ist, jowoils mit einem elektrisch leitfähigen Element verbunden sind, wodurch eine Betriebsspannung an dem wenigstens einen elektrisch leitfähigen Element anliegt und durch dieses elektrischer Strom fließt, wobei sich zwischen Wandung des Reaktors und Elektrode jeweils eine Dichtung aus einem isolierenden Material befindet, wobei wenigstens in einer dieser Dichtungen ein elektrisch leitender Dichtungskern eingebettet ist, wobei der elektrisch leitende Dichtungskern mit einem Isolationsüberwachungsgerät oder mit einem Hilfsspannungsnetz verbunden ist, wobei mittels Überwachung eines Isolationswiderstand des Dichtungskerns oder mittels Überwachung eines Stromflusses im Hilfsspannungsnetz durch Dichtungsschäden ermöglichte Kriechströme identifiziert werden.

2. Verfahren nach Anspruch 1, wobei im Falle von mehreren Elektroden im Reaktor mehrere leitfähige Dichtungskerne eines Reaktors außerhalb oder innerhalb des Reaktors elektrisch verbunden sind und einmalig der Isolationswiderstand gegen den Reaktorbehälter überwacht wird.

3. Verfahren nach Anspruch 1, wobei im Falle von mehreren Elektroden i.m Reaktor der Isolationswiderstand jeder einzelnen Elektrodendichtung oder der Isolationswiderstand in mehreren Gruppen überwacht wird.

4. Verfahren nach einem der Ansprüche 1 bis 3, wobei das Material des Dichtungskerns ausgewählt wird aus der Gruppe bestehend aus Metalle, Graphit, Kohlenstoff und leitfähige Kunststoffe.

5. Verfahren nach einem der Ansprüche 1 bis 4, wobei der spezifische elektrische Widerstand des Dichtungskerns kleiner als 1/100 des spezifischen elektrischen Widerstands des Dichtungsmaterials ist.

6. Verfahren nach einem der Ansprüche 1 bis 5, wobei der Dichtungskern die Form eines Ringes, Gitters oder einer Fasermatte hat und jeweils mit elektrischer Anschlussöglichkeit ausgestattet ist.

7. Verfahren nach einem der Ansprüche 1 bis 6, wobei das Hilfsspannungsnetz mittels Sicherungen oder einer beliebigen Strommessung mit Schaltschwellen überwacht wird.

8. Verfahren nach Anspruch 7, wobei für mehrere Elektroden ein Hilfsspannungsnetz benutzt wird.

9. Verfahren nach Anspruch 7 oder Anspruch 8, wobei die Stromüberwachung der einzelnen Elektrodenkontakte einzeln oder für alle Elektroden gemeinsam erfolgt.

## Claims

1. Method for supplying current to a reactor, wherein one or more electrodes, which are fed through a wall of the reactor, of an electrical energy network which is DC-isolated from ground potential are respectively connected to an electrically conductive element so that an operating voltage is applied to the at least one electrically conductive element and electrical current flows through it, wherein there is respectively a seal made of an insulating material between the wall of the reactor and the electrode, wherein an electrically conductive seal core is embedded in at least one of these seals, wherein the electrically conductive seal core is connected to an insulation monitoring apparatus or to an auxiliary voltage network, and wherein leakage currents made possible by seal damage are identified by means of monitoring an insulation resistance of the seal core or by means of monitoring a flow of current in the auxiliary voltage network.

2. Method according to Claim 1, wherein, in the case of a plurality of electrodes in the reactor, a plurality of conductive seal cores of a reactor are electrically connected outside or inside the reactor and the insulation resistance with respect to the reactor vessel is monitored once.

3. Method according to Claim 1, wherein, in the case of a plurality of electrodes in the reactor, the insulation resistance of each individual electrode seal or the insulation resistance in a plurality of groups is monitored.

4. Method according to one of Claims 1 to 3, wherein the material of the seal core is selected from the group consisting of metals, graphite, carbon and conductive plastics.

5. Method according to one of Claims 1 to 4, wherein the electrical resistivity of the seal core is less than 1/100 of the electrical resistivity of the seal material.

6. Method according to one of Claims 1 to 5, wherein the seal core is in the form of a ring, grid or a fiber mat and is respectively equipped with an electrical connection facility.

7. Method according to one of Claims 1 to 6, wherein the auxiliary voltage network is monitored by means of fuses or an arbitrary current measurement with switching thresholds.

8. Method according to Claim 7, wherein one auxiliary voltage network is used for a plurality of electrodes.

9. Method according to Claim 7 or Claim 8, wherein the current monitoring of the individual electrode contacts is carried out individually or for all the electrodes together.

## Revendications

1. Procédé pour alimenter en courant un réacteur, dans lequel une ou plusieurs électrodes, passées à travers une paroi du réacteur, d'un réseau énergie électrique isolé galvaniquement vis-à-vis de la terre sont chacune raccordée à un élément électriquement conducteur de telle sorte qu'une tension de service soit appliquée sur le ou les éléments électriquement conducteurs et qu'un courant électrique s'écoule dans ces derniers,
un joint d'étanchéité en matériau isolant étant situé entre la paroi du réacteur et chaque électrode,
une âme de joint d'étanchéité, électriquement conductrice, étant incorporée dans l'un de ces joints d'étanchéité,
l'âme électriquement conductrice de joint d'étanchéité étant raccordée à un appareil de surveillance de l'isolation ou à un réseau à tension auxiliaire,
la surveillance de la résistance d'isolation de l'âme de joint d'étanchéité ou la surveillance d'un courant s'écoulant dans le réseau à tension auxiliaire permettant d'identifier les courants de fuite occasionnés par des dommages infligés au joint d'étanchéité.

2. Procédé selon la revendication 1, dans lequel au cas où plusieurs électrodes sont prévues dans le réacteur, plusieurs âmes conductrices de joint d'étanchéité d'un réacteur sont raccordées électriquement à l'intérieur ou à l'extérieur du réacteur et dans lequel la résistance de l'isolation vis-à-vis du récipient du réacteur est surveillée une seule fois.

3. Procédé selon la revendication 1, dans lequel au cas où plusieurs électrodes sont prévues dans le réacteur, la résistance de l'isolation est surveillée pour chaque joint d'étanchéité d'électrode ou la résistance de l'isolation est surveillée en plusieurs groupes.

4. Procédé selon l'une des revendications 1 à 3, dans lequel le matériau de l'âme de joint d'étanchéité est sélectionné dans l'ensemble constitué des métaux, du graphite, du carbone et des matières synthétiques conductrices.

5. Procédé selon l'une des revendications 1 à 4, dans lequel la résistance électrique spécifique de l'âme de joint d'étanchéité est inférieure à 1/100 de la résistance électrique spécifique du matériau du joint d'étanchéité.

6. Procédé selon l'une des revendications 1 à 5, dans lequel l'âme de joint d'étanchéité présente la forme d'un anneau, d'une grille ou d'un tapis de fibres et est dotée en tout cas d'une possibilité de raccordement électrique.

7. Procédé selon l'une des revendications 1 à 6, dans lequel le réseau à tension auxiliaire est surveillé au moyen de protections ou d'une mesure quelconque de courant avec seuils de commutation.

8. Procédé selon la revendication 7, dans lequel un réseau à tension secondaire est utilisé pour plusieurs électrodes.

9. Procédé selon la revendication 7 ou la revendication 8, dans lequel la surveillance du courant des différents contacts d'électrodes s'effectue séparément pour chaque électrode ou en commun pour toutes les électrodes.
